# EUROPEAN PATENT SPECIFICATION

(11) **EP 3 940 869 B1**
(45) Date of publication and mention of the grant of the patent: **01.01.2025**
(21) Application number: 21182649.0
(22) Date of filing: 30.06.2021
(51) Int. Cl.: H01M 10/48, H01M 50/213, H01M 50/291, H01M 50/293, H01M 10/42

(54) **BATTERY CELL TEMPERATURE MONITORING**
BATTERIEZELLENTEMPERATURÜBERWACHUNG
SURVEILLANCE DE LA TEMPÉRATURE DE CELLULE DE BATTERIE

(30) Priority: 16.07.2020 GB 202010944
(43) Date of publication of application: 19.01.2022
(73) Proprietor: Rolls-Royce plc, London N1 9FX (GB)
(72) Inventor: Holdsworth, Joseph, Derby DE24 8BJ (GB)
(74) Representative: Rolls-Royce plc

(56) References cited:
- EP-A1- 3 525 279
- US-A1- 2011 210 703
- US-A1- 2012 028 084
- US-A1- 2016 260 943
- US-A1- 2019 131 672

## Description

### Technical Field

The present disclosure relates to the monitoring of temperatures in a battery assembly, particularly but not exclusively a battery assembly for an aircraft propulsion system.

### Background

Future aerospace applications including more electric, hybrid electric and purely electric aircraft will likely use high voltage battery packs made up of a number of series- and/or parallel- connected battery modules. These battery packs may, for example, be used to power one or more motors used to propel the aircraft and/or to provide power to one or more ancillary systems.

Heating of battery cells beyond their normal operating range can occur for various reasons. For example, a fault may develop in one or more of the modules, or the modules could be exposed to an external source of heat such as a fire, direct sunshine or exhaust gas from a gas turbine engine. Heat from one battery module can spread to others, which could lead to thermal runaway of an entire battery pack. Excessive heating and thermal runaway creates a risk of fire and with it damage to the battery pack, damage to the surrounding structure of the aircraft and risk of electric shock, for example by causing damage to electrical insulation and structures that support the cells and bus bars.

It is desirable to monitor temperatures arising in the battery pack to check its operation and to protect against the consequences of excessive cell heating. Some systems may monitor battery temperatures at a module level. Future aerospace applications may however require temperature monitoring at a more granular level.

European Patent Application publication EP 3525279 A1 relates to a battery pack with thermistors on flexible layers for temperature measurement.

United States Patent Application publication US 2019/0131672 A1 relates to a battery module with a PCB sensing assembly.

United States Patent Application publication US 2012/0028084 A1 relates to a spacer for a battery pack.

### Summary of the Disclosure

The present disclosure provides a battery assembly that uses flexible PCBs to incorporate temperature sensing capability at a more granular level. Methods of assembling a battery assembly are also provided.

According to a first aspect there is provided a battery assembly comprising: an array of cylindrical battery cells, the array comprising plural rows, each row comprising plural cells, the plural rows including at least a first row, a second row adjacent to the first row and, and a third row adjacent to the second row, each cylindrical cell extending between opposed first and second ends in a direction perpendicular to a plane of the array; a flexible printed circuit board, PCB, provided between two adjacent rows of the plurality of rows of cells; a plurality of sensor carriers separate to the flexible PCBs, each sensor carrier comprising an aperture for receiving a temperature sensor in the direction perpendicular to the plane of the array, each sensor carrier being located in a gap formed between cells of two adjacent rows; and a plurality of temperature sensors, each temperature sensor received within the aperture of one of the sensor carriers, each temperature sensor electrically connected to one of the plurality of flexible PCBs, each temperature sensor being operable to sense a temperature of one or more cells of the two adjacent rows.

The gap may be a central gap between four cells, the four cells consisting of two cells from a first of the two rows and two cells from a second of the two rows.

The sensor carrier is separate to, but may be held in contact by, the flexible PCBs. The carrier may be shaped to cooperate with shapes of the cells surrounding the gap. The carrier comprises one or more apertures, for example central apertures, for receiving one or more temperature sensors. The carrier may comprise arcuate extensions for cooperating with the shape of circular cells, for example three or four arcuate extensions.

The cells of adjacent rows of the array may be offset with respect to each other, and each temperature sensor may be provided in a gap formed between a group of three cells, the three cells consisting of first and second cells belonging to one of the two rows and a third cell belonging to the other of the two rows and adjacent to the first and second cells.

The cells of adjacent rows may be offset with respect to each other by half a cell width, which may conveniently mean that each gap is of equivalent size. Alternatively they may be offset by more or less than half a cell or may not be offset at all.

The flexible PCB may be attached, for example adhesively attached, to side walls of the cells of one or both of the two adjacent rows. Other attachments means such as fasteners may also be used.

The battery assembly may further comprise an additional flexible PCB affixed to an outer facing surface or side wall of the cells of an outermost row of the array. The additional flexible PCB may be electrically coupled to a plurality of additional temperature sensors, each of the plurality of additional temperature sensors operable to sense a temperature of one or more cells of the outermost row. Each additional temperature sensor may be in physical contact with the side wall of one of the cells, and may be held in place by the flexible PCB. There may be one temperature sensor per cell for the outermost row of cells.

Each cell may have a side wall extending perpendicular to a plane of the array. Each temperature sensor may be positioned at the same distance along the side wall, as measured from one end of the cell.

The or each flexible PCB may be electrically connected to an onward electrical path at one end of the row or rows of cells to which it is adjacent. Electrical signals generated by a temperature sensor may be transmitted to the onward electrical path via the flexible PCB to which the temperature sensor is electrically connected.

The cells of each respective row of cells may be electrically connected together in parallel.

The battery assembly may be one of a plurality of electrically connected modules or sub-modules of a battery pack.

According to a second aspect, there is provided an aircraft propulsion system comprising a battery assembly according to the first aspect.

According to a third aspect there is provided an aircraft comprising a battery assembly according to the first aspect or an aircraft propulsion system according to the second aspect. The aircraft may be an electric or hybrid electric aircraft.

The terms "battery assembly", "battery module", "battery channel" and "battery pack" are used herein in a general sense to refer to electrical energy storage units that include various arrangements of electrically connected battery cells. The term "battery pack" is generally used to refer to an arrangement comprising one or more independent battery channels. The term "battery channel" is generally used to refer to an arrangement comprising one or more electrically connected battery modules. The term "battery module" is generally used to refer to an arrangement comprising one or more electrically connected battery assemblies. The term "battery assembly" is generally used to refer to any arrangement comprising one or more electrically connected battery cells. The battery cells may be cylindrical cells or another type of cell, for example pouch cells or prismatic cells.

The skilled person will appreciate that except where mutually exclusive, a feature described in relation to any one of the above aspects may be applied mutatis mutandis to any other aspect. Furthermore except where mutually exclusive any feature described herein may be applied to any aspect and/or combined with any other feature described herein.

### Brief Description of the Drawings

Embodiments will now be described by way of example only, with reference to the Figures, in which:
**Figure 1** is a sectional side view of a gas turbine engine;
**Figure 2A** is a schematic illustration of a hybrid electric aircraft propulsion system;
**Figure 2B** is a schematic illustration of a purely electric aircraft propulsion system;
**Figure 3** illustrates components of a modular battery pack;
**Figure 4A** is a perspective view of part of a battery assembly incorporating a flexible PCB for cell temperature monitoring;
**Figure 4B** illustrates the positioning of a temperature sensor with respect to adjacent cells and a flexible PCB;
**Figure 4C** is a perspective and partially transparent view of a three adjacent battery cells and a temperature sensor;
**Figure 5A** illustrates several flexible PCBs sandwiched between adjacent rows of cells in a battery assembly;
**Figure 5B** is a side-on view of a battery assembly showing a flexible PCB provided on an outermost row of cells;
**Figure 6A** is a perspective view of a battery assembly incorporating flexible PCBs for cell temperature monitoring;
**Figure 6B** is a plan view of the two halves of the battery assembly of Figure 6A showing the locations of temperature sensors; and
**Figure 7** is a flow chart illustrating a method of assembling a battery assembly.

### Specific Description

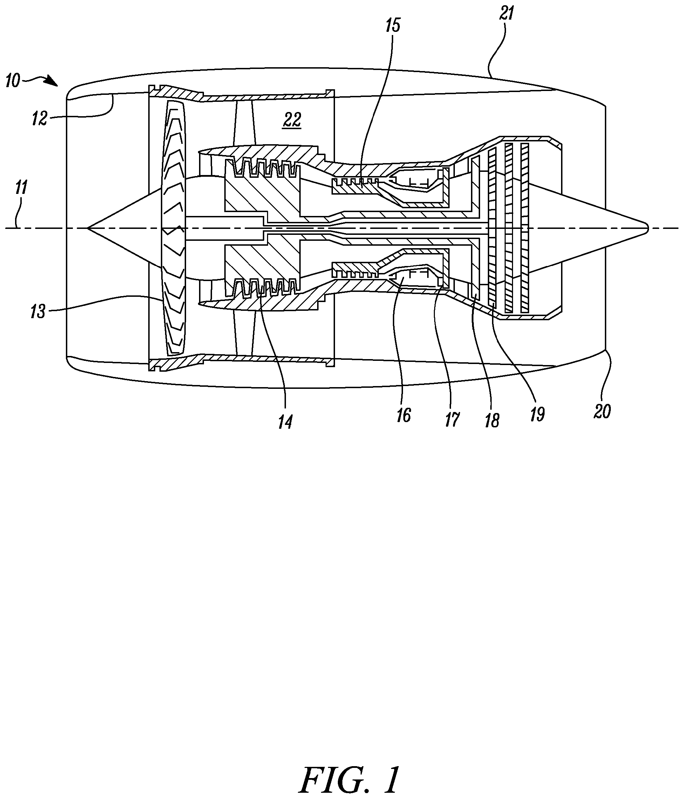

With reference to **Figure 1****,** a gas turbine engine is generally indicated at 10, having a principal and rotational axis 11. The engine 10 comprises, in axial flow series, an air intake 12, a propulsive fan 13, an intermediate pressure compressor 14, a high-pressure compressor 15, combustion equipment 16, a high-pressure turbine 17, an intermediate pressure turbine 18, a low-pressure turbine 19 and an exhaust nozzle 20. A nacelle 21 generally surrounds the engine 10 and defines both the intake 12 and the exhaust nozzle 20.

The gas turbine engine 10 works in the conventional manner so that air entering the intake 12 is accelerated by the fan 13 to produce two air flows: a first air flow into the intermediate pressure compressor 14 and a second air flow which passes through a bypass duct 22 to provide propulsive thrust. The intermediate pressure compressor 14 compresses the air flow directed into it before delivering that air to the high pressure compressor 15 where further compression takes place.

The compressed air exhausted from the high-pressure compressor 15 is directed into the combustion equipment 16 where it is mixed with fuel and the mixture combusted. The resultant hot combustion products then expand through, and thereby drive the high, intermediate and low-pressure turbines 17, 18, 19 before being exhausted through the nozzle 20 to provide additional propulsive thrust. The high 17, intermediate 18 and low 19 pressure turbines drive respectively the high pressure compressor 15, intermediate pressure compressor 14 and fan 13, each by suitable interconnecting shaft.

Other gas turbine engines to which the present disclosure may be applied may have alternative configurations. By way of example such engines may have an alternative number of interconnecting shafts (e.g., two) and/or an alternative number of compressors and/or turbines. Further the engine may comprise a gearbox provided in the drive train from a turbine to a compressor and/or fan. The gas turbine engine may also incorporate or interface with one or more batteries, for example to power ancillary electrical systems and/or to cooperate with one or more electric machines involved in the transfer of mechanical power to and from one or more of the interconnecting shafts.

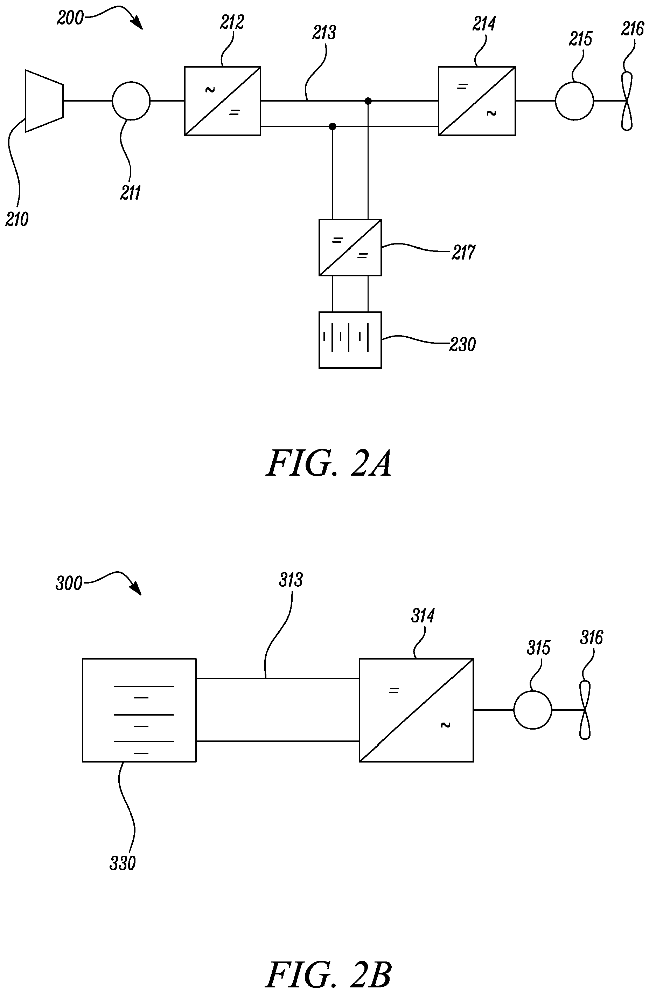

Now referring to **Figure 2A****,** the propulsion system of a hybrid electric aircraft is generally indicated 200 and incorporates both an engine 210, such as the gas turbine engine 10 described above with reference to Figure 1, and a battery pack 230. Both the engine 210 and the battery pack 230 are used as energy sources to power a motor-driven propeller 216, as well as ancillary electrical systems (not shown). The propulsion system 200 of the hybrid electric aircraft will typically further comprise a generator 211, an AC/DC converter 212, a high voltage DC (HVDC) distribution bus 213, a DC/AC converter 214, a motor 215 that drives the propeller 216, and a DC/DC converter 217.

A shaft of the engine 210 is coupled to and drives the rotation of a shaft of the generator 211 which thereby produces alternating current. The AC/DC converter 212, which faces the generator 211, converts the alternating current into direct current which is fed to various electrical systems via the HVDC distribution bus 213. These electrical systems include the motor 215 that drives the propeller 216. The motor 215 will typically be a synchronous motor that interfaces with the HVDC distribution bus 213 via the DC/AC converter 214.

The battery pack 230, which may be made up of a number of lithium ion battery modules connected in series and/or parallel, is connected to the HVDC distribution bus 213 via the DC/DC converter 217. The DC/DC converter 217 converts between a voltage of the battery pack 230 and a voltage of the HVDC distribution bus 213. In this way, the battery pack 230 can replace or supplement the power provided by the engine 210 (by discharging and thereby feeding the HVDC distribution bus 213) or can be charged using the power provided by the engine 210 (by being fed by the HVDC distribution bus 213).

A battery pack will also appear in the propulsion system of a purely electric aircraft, generally indicated as 300 in **Figure 2B****.** The battery pack 330 feeds a HVDC distribution bus 313, possibly via DC/DC converter (not shown), which delivers power to one or more synchronous motors 315 via a DC/AC converter 314. The one or more motors 315 drive the one or more propellers 316 that propel that aircraft.

Battery packs used in these applications may have high terminal voltages, for example 500V to 3kV. The use of high voltages advantageously allows for a reduction in the weight of the power distribution cabling, but it does create risk factors. For example, a fault within one or more of the battery modules could lead to cell overheating, which in turn creates a risk of thermal runaway, fire and electric shock.

In order to mitigate the risk of cell overheating, it is desirable to measure the temperatures arising in the battery pack. However, making direct temperature measurements can prove difficult, especially if it is desired to measure temperatures at a granular level, for example at the level of one or several cells. This difficulty is, in part, because of the typically dense packing of cells in battery packs used in these and other applications. Dense cell packing is generally required in view of space constraints and the need to supply battery packs with a high power density.

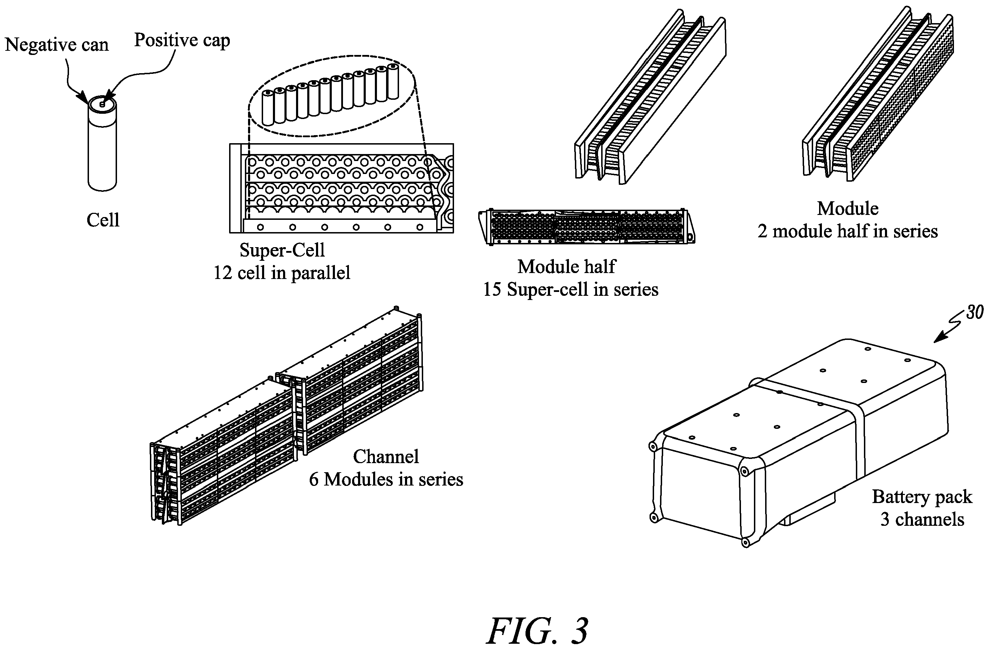

To illustrate this problem, **Figure 3** shows the construction of an exemplary battery pack. It is to be understood that the design shown in Figure 3 is not intended to limit the present disclosure, but rather to illustrate how a battery pack may be constructed and may include a large number of densely packed cells.

Referring first to the top row of images, the left-most image shows a single battery cell, in this case a 4.2V 18650 cylindrical cell having positive and negative terminals located at the same top end of the cell. In the next image, twelve of the cells are provided in a row and are connected in parallel, via a collector in the form of a bus bar adjacent to the row, to form a super-cell. Five super-cell rows are then connected together in series to form a five-row array of super-cells having a total voltage of about 20V and including sixty tightly packed cylindrical cells. In the next image, three of these arrays (totalling fifteen super-cells) are connected together in series to form a module-half having a terminal voltage of about 60V. In the final image of the top row, two of the module-halves are connected together in series to form a battery module having a terminal voltage of approximately 120V. It will be appreciated that, in this example, the battery module includes 360 of the cylindrical cells.

Now referring to the bottom row of images, in the left hand image a battery channel is formed by connecting six of the battery modules together in series. The channel thus has a terminal voltage of about 720V and consists of 2,160 cells. Finally, in the right hand image, a battery pack includes a battery case that houses three of the battery channels. That is, the battery pack includes three independent 720V power supplies each having 2,160 battery cells, for a total of 6,480 cells. It will of course be appreciated that the battery pack could have any number of channels, including one channel.

It can be appreciated that the battery pack is densely packed with cells. What little space remains in the battery pack is mostly taken up by carrier frame material, which is included to provide adequate structure and protection. Further space is taken up by the electrical connections that connect the cells together and to onward electrical paths, and by various cooling systems for carrying heat away from the cells.

This dense packing results in very little space for the provision of additional components such as temperature sensors. Whilst one or two sensors per module or module-half may be included, finding room to provide additional temperature sensors becomes increasingly difficult. Furthermore, each temperature sensor must be connected to an onward electrical path, and the number of sensor connections can quickly become overwhelming given the number of cells in the pack, in this case 6,480 cells.

To address these and other problems, the present disclosure utilizes flexible PCBs, which can be sandwiched between adjacent rows of cells, to provide electrical connections to and from temperature sensors positioned in the core of a battery assembly.

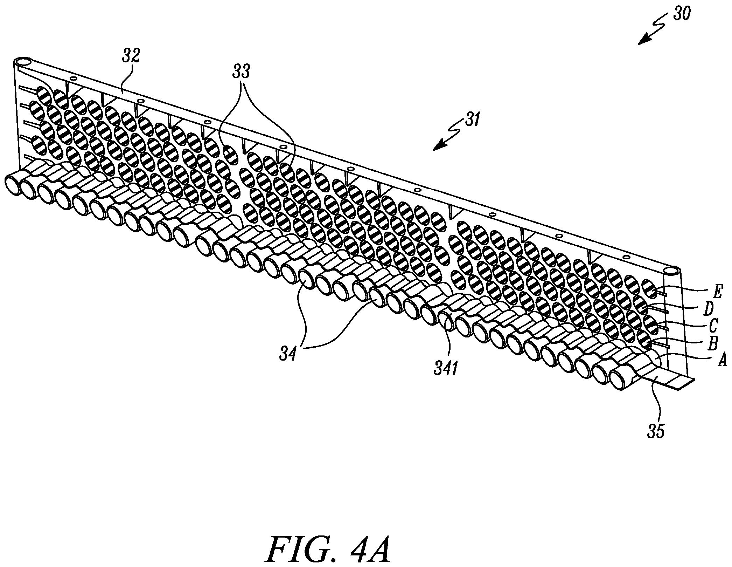

**Figure 4A** illustrates a partially assembled array 31 of battery cells 34 that is or forms part of a battery assembly 30. The term "battery assembly" 30 as used herein is a general term that encompasses entire battery packs; battery modules that when connected to other battery modules form a battery pack; and any other battery assembly that includes one or more arrays of battery cells.

The battery assembly 30 includes a carrier frame 32 that includes an approximately rectangular array 31 of apertures 33 that are sized and shaped to receive battery cells 34. In this example the cells 34 are cylindrical cells, and so the apertures 33 are circular in cross-section. The carrier frame 32 provides the battery assembly 30 with structural rigidity while the apertures 33 accurately locate the cells 34 in their intended positions.

The array 31 includes a plurality of rows; in this case five rows labelled A, B, C, D and E (A-E). Each row A-E includes a plurality of apertures 33 for a corresponding plurality of cells 34; in this case thirty-six apertures 33 for thirty-six cells 34. The array 31 lies in a plane, with each row extending along one direction in the plane. Without loss of generality this direction will be designated the x-direction. Adjacent rows are offset in a direction perpendicular to the x-direction, which will be described as the y-direction. The cells 34 themselves extend perpendicular to the plane of the array 31, in the z-direction.

In Figure 4A the battery assembly 30 is only partially assembled, with the cells 34 of only one of the rows, row A, received within the respective apertures 33. In accordance with the present disclosure, before inserting the cells of the adjacent row B within their apertures, a thin and flexible printed circuit board (PCB) 35 is provided over the inside facing side walls 341 of the cells 34 of the first row A. In this way, when the cells 34 of the adjacent row B are inserted into their apertures, the flexible PCB 35 will be sandwiched between the two adjacent rows A, B.

The flexible PCB 35 extends the entire length of the row A and incorporates electrical conduits for carrying electrical signals. In this way, the flexible PCB 35 is able to provide electrical connections to and from temperature sensors 36 (not visible in Figure 4A) that are provided between the adjacent rows A, B. The location of the temperature sensors 36 between the rows A, B will be described in more detail below.

Any suitable flexible PCB 35 may be used. For example, a PCB made of a thin, electrically insulating substrate (for example a polyamide film) with embedded conductors can be used. The flexibility of the PCB 35 allows it to conform to the surfaces of the sidewalls 341 of the cells 34. Conveniently, one or both major surfaces of the flexible PCB 34 may be covered in an adhesive so that the flexible PCB 35 can be affixed to the side walls 341 without additional fixings.

In order to monitor the temperatures of the cells 34 of the two adjacent rows A, B, temperature sensors 36 are provided in spaces between the rows A, B. The preferred locations of the temperatures sensors 36 will, to some extent, depend on the chosen geometry of the array 31 of the battery assembly 30 and the resulting locations of spaces in the array.

In some examples, there may be sufficient space in the y-direction between adjacent rows A, B for temperature sensors 36 to be provided adjacent to (for example in direct contact with) the inside facing side walls 341 of the cells 34. In other words, a temperature sensor 36 may be sandwiched between the flexible PCB 35 and a cell 34 of one of the two rows A, B. In this way, a temperature sensor 36 may be operable to monitor the skin temperature of the cell(s) 34 to which it is adjacent. Temperature sensors 36 may be provided adjacent to each cell 34 or only some of the cells of the two rows A, B.

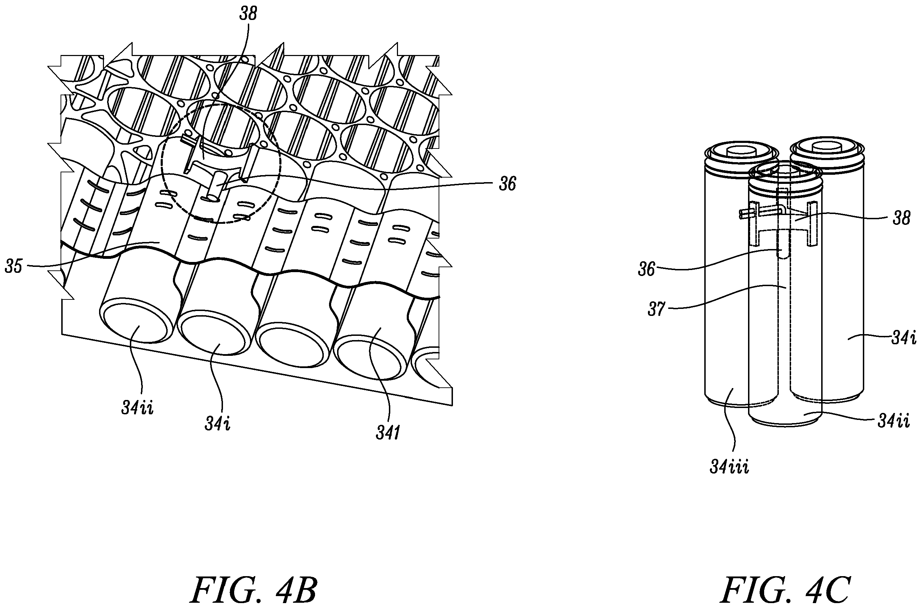

In other examples, the cells 34 of the array 31 may be so tightly packed that there is insufficient space in the y-direction for temperature sensors 36 to be sandwiched between the flexible PCB 35 and the side wall of a cell 34. Thus, in this and other examples, temperature sensors 36 may be provided in other available spaces in the array 31. This is illustrated in **Figures 4B and 4C****,** which show a temperature sensor 36 located within a gap 37 that is defined between three adjacent battery cells 34i, 34ii, 34iii.

In more detail, it can be seen from Figures 4A and 4B that adjacent rows of the plurality of rows A-E are offset from each other, in the x-direction, by half the width of a cell 34. That is, the cells 34 of each row (e.g., row B) are shifted, relative to the cells 34 of the neighbouring row(s) (e.g., A, C), by a distance in the x-direction. Thus the centres of the cells 34 of adjacent rows are not aligned in the y-direction. The result is that, when considering the cells of two adjacent rows (e.g., A, B), the cells 34 form groups of three cells: two cells 34i, 34ii of one row (A) and a third cell 34iii of the other row (B) that is staggered in the x-direction half way between the first two cells 34i, 34ii. Such a group of three cells 34i, 34ii, 34iii is shown in Figure 4C.

Due to the circular cross-section of the cells 34, a gap 37 (visible in the semi-transparent view of Figure 4C) is formed between the three cells 34i, 34ii, 34iii that can accommodate a temperature sensor 36. The temperature sensor 36 located in the gap 37 is operable to measure a temperature in its vicinity, for example a temperature representative of one of the three cells 34i, 34ii, 34iii or an average temperature of the three cells 34i, 34ii, 34iii. As can be best seen in Figure 4B, the sensor 36 can be readily electrically connected to the electrical conduits of the flexible PCB 35 that passes between the two rows A, B. The sensor 36 may be adhesively attached to the surface of the flexible PCB 35 so as to keep the sensor is a substantially constant position relative to the side walls of the cells 34.

Figures 4B and 4C also illustrate how a temperature sensor 36 may be held by or within a sensor carrier 38, which may be formed of a plastic or another suitable material. The sensor carrier 38 may include a central slot that is sized and shaped to receive and firmly hold the sensor 36 in place. Further, the outer surfaces of the carrier 38 may be sized and shaped to conform to the curved sidewalls of the three cells 34i, 34ii, 34iii so that the carrier 38 can sit by or be fixed to the side walls of the three cells. In this specific case the carrier 38 comprises three arcuate surfaces corresponding to arcuate portions of the cylindrical sidewalls of the three cells 34i, 34ii, 34iii of the group.

Although the example illustrated in Figures 4A-4C utilizes cylindrical cells, with adjacent rows staggered by half a cell width, it should be understood that other possibilities are within the scope of present disclosure. For example:
- The rows A-E of the array 31 may not be staggered at all. In this case, the gaps 37 accommodating the sensors 36 may be defined between four adjacent cells: two cells of one row (A) and two cells of an adjacent row (B).
- Adjacent rows A-E of the array 31 may be staggered by more or less than half a cell width. In this case the size of the gaps 37 defined by groups of three cells 34i, 34ii, 34iii may vary along the length of a row. Only some of these gaps may be selected for accommodating sensors 36, for example if only some of the gaps are suitably sized for accommodating a sensor of a given size.
- The cells 34 may not be of circular cross-section. Gaps 37 between cells of adjacent rows will be defined for essentially any non-rectangular cross-section. For rectangular cross-sections, gaps 37 may still be defined because there is at least some material thickness between adjacent apertures 33.
- Where sensor carriers 38 are provided, different sizes and shapes can be used according to the geometry of the array 31 and the cross-sections of the cells 34.

Any suitable temperature sensor 36 can be used. In one example, the temperature sensors 36 are standard PT1000 and/or LM50 temperatures sensors.

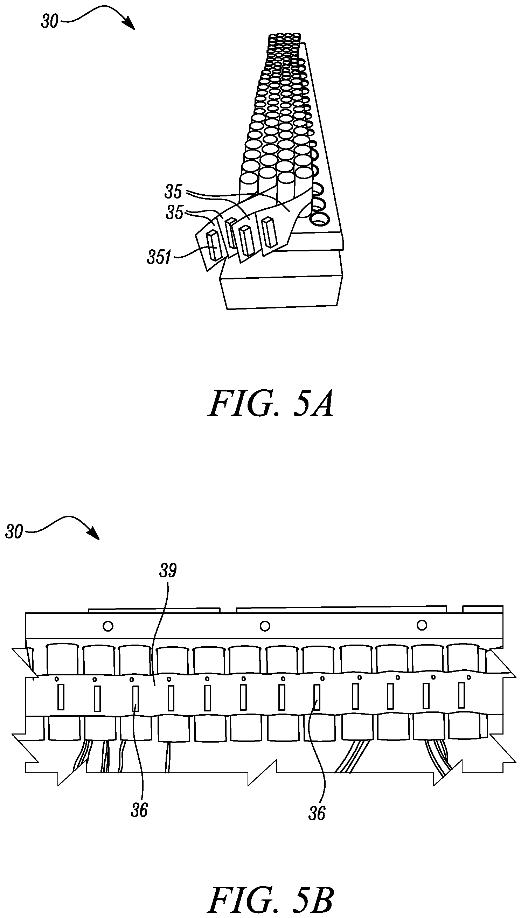

Now turning to **Figure 5A****,** this shows the battery assembly 31 of Figure 4A but with the cells 34 of four rows A-D of the five rows A-E received within the carrier frame 32. Flexible PCBs 35 have been provided over the inside facing surfaces of each of the four rows A-D such that, in Figure 5A, there are four flexible PBCs 35. Also visible are the ends of the rows of the flexible PCBs 35, which can be seen to terminate in connectors 351 by which the electrical conduits of the flexible PCBs 35 can be connected to onward electrical paths. These may, ultimately, lead to a battery management system (BMS) or the like that is operable to control the battery assembly 30 based at least in part on the temperature measurements received from the sensors 36.

**Figure 5B** shows how an additional flexible PCB 39 may be provided over an outside facing surface of an outermost row of cells 34 of the array 31. Generally speaking, space is at less of a premium at the outermost rows of cells 34. As such, temperature sensors 36 may be provided adjacent to (for example in direct contact with) the side walls 341 of the cells 34 rather than within the gaps defined between cells. In Figure 5B it can be seen that each of the cells 34 are equipped with a temperature sensor 36 (visible as a cylindrical bulge in the PCB 39) that is sandwiched between flexible PCB 39 and the side wall of the cell 34. No sensor carrier 38 is utilized in this case, and the flexible PCB 39 helps locate the sensors 36 in a consistent position along the length of the side walls of the cells 34.

So that the temperatures sensed by the temperature sensors 36 can be reliably interpreted, the sensors 36 are preferably located in consistent environments. For example, it is generally expected that there will be a thermal gradient across each cell. Thus, to eliminate the effects of the thermal gradients on the interpretation of the sensor readings, each temperature sensor may be positioned at the same vertical distance along the z-axis. Further, where the offset between adjacent rows is greater or less than half a cell width, such that gaps 37 are of variable sizes, sensors 36 may be placed only in equivalently sized and shaped gaps.

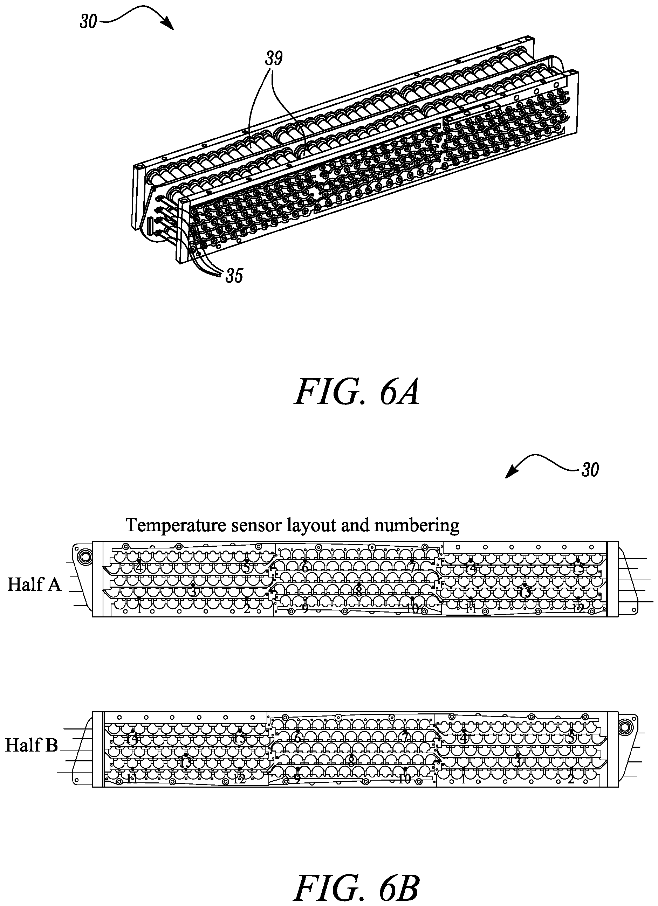

**Figure 6A** shows a more completely assembled battery assembly 30, similar to the battery module shown in Figure 3. For temperature monitoring purposes, flexible PCBs 35 are sandwiched between rows of battery cells 34, and additional flexible PCBs 39 are provided on outside facing surfaces of the outermost rows. At the row ends, the flexible PCBs 35, 39 are connected to their onward electrical paths so that the temperatures sensed by the temperature sensors 36 (not visible in Figure 6A) can be communicated on for monitoring, for example a BMS.

The number and location of the temperature sensors 36 within the battery assembly 30 can be varied according to the application requirements and constraints. In some cases there may be one temperature sensor 36 for each and every cell 34 in the battery assembly 30. In other examples, there may be an average of less than one temperature sensor 36 per cell 34, with sensor locations selected so as to provide adequate temperature monitoring across the pack and/or to monitor the temperature of expected 'hotspots'. For instance, one temperature sensor 36 may be provided for every two, three, four, five or six cells.

To illustrate this, **Figure 6B** marks exemplary locations of temperature sensors in the core regions of the two halves of the battery assembly of Figure 6A. As can be seen in Figure 6B, not every gap 37 that is defined between a group of three cells 34i, 34ii, 34iii is provided with a temperature sensor 36. Instead, thirty sensors are distributed between the two halves of the assembly, with fifteen sensors per half. Each half has five rows A-E and, in this case, every second row is provided with six temperatures sensors spaced approximately evenly along the length of the row. Each of these temperature sensors is operable to sense the temperature of three adjacent cells 34i, 34ii, 34iii. Such an arrangement may provide temperature monitoring coverage across the majority of the core of the battery assembly 30, without adding to size of the assembly or introducing an overwhelming arrangement of connections.

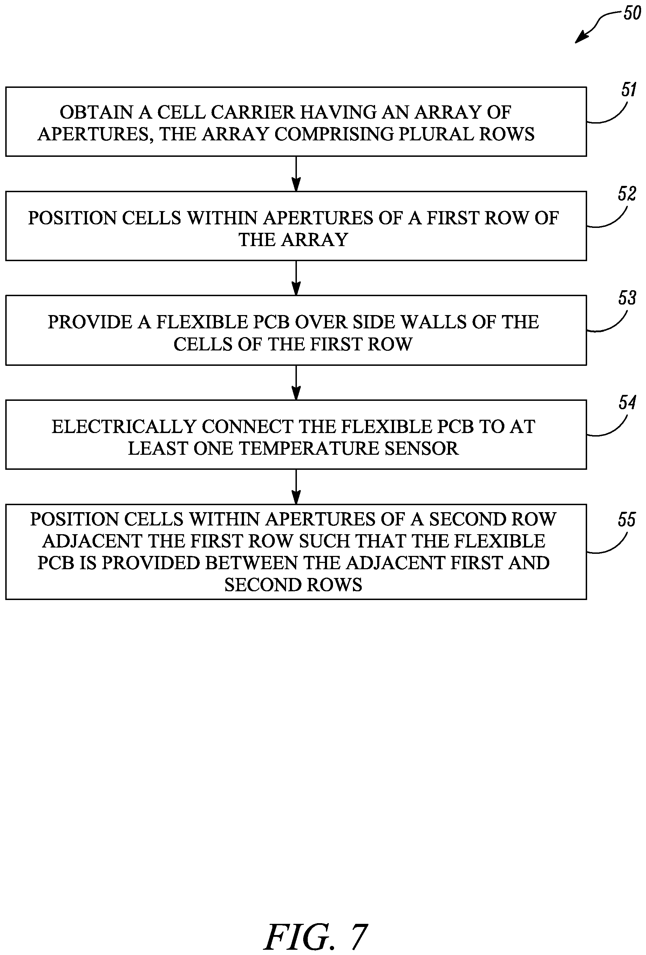

**Figure 7** is a flow chart illustrating a method 50 of assembling a battery assembly 30 in accordance with the present disclosure. It should be understood that, except where the context dictates otherwise, the steps 51-55 need not take place in the order described below.

At 51, a carrier frame 32 is obtained. The carrier frame 32 includes an array 31 of apertures 33 that are sized and shaped to receive battery cells 34. The array includes plural rows A-E, and each of the rows includes plural apertures 33 for a corresponding plurality of cells 34.

The carrier frame 32 may be formed of any suitable material, for example a plastic material or other electrical insulator. The apertures 33 may be sized and shaped to receive cells of any suitable geometry, for example cylindrical cells. The array 31 can have any suitable geometry. As explained above, the apertures 33 of adjacent rows may be staggered in the x-direction so as to form groups of three apertures, each defining a gap 37 at the centre of the group.

At 52, battery cells 34 are positioned within the apertures of a first row (A) of the array. The first row may be any one of the rows of the array.

At 53, a flexible PCB 35 is provided over inside facing side walls 341 of the cells 34 of the row. The flexible PCB 35 is typically a thin, electrically insulating substrate having electrical conduits extending along its length. One or both major surfaces of the flexible PCB 35 may include an adhesive allowing it to be readily attached to the side walls 341 of the cells 34.

At 54, at least one temperature sensor 36 is electrically connected to the flexible PCB 35. The sensors 36 may be physically attached to the flexible PCB 35, for example by adhesive. The sensors may be placed in gaps 37 between cells 34.

At 55, cells 34 of a second row (B) of the array adjacent to the first row (A) are positioned within the apertures of the second row. The cells 34 are positioned such that the flexible PCB 35 is provided between the adjacent first and second rows of cells.

The temperature sensors of step 54 are positioned adjacent to the flexible PCB 35 and operable to sense a temperature of one or more cells 34 of the two adjacent rows (A, B). Each temperature sensor 36 may sense the temperature of one cell, two cells or, in one particular example, an average temperature of three adjacent cells 34i, 34ii, 34iii.

Advantages associated with the techniques of the present disclosure may include one or more of the following:
i. Temperature sensing of an increased fraction of the total number of cells in a battery assembly.
ii. The sensing of temperatures of cells in the core of a battery assembly, without having to increase the distance between adjacent cells and adjacent rows of cells.
iii. The consistent placement of temperature sensors relative to cells, reducing or eliminating the effect of temperature gradients on the interpretation of sensor readings.
iv. The connection of temperature sensors to onward electrical paths without a large number of trailing connections.
v. Relatively low increase in assembly mass.
vi. Scalability.

## Claims

1. A battery assembly (30) comprising:
an array (31) of cylindrical battery cells (34), the array comprising plural rows (A-E), each row comprising plural cylindrical cells, the plural rows including at least a first row (A), a second row (B) adjacent to the first row, and a third row (C) adjacent to the second row (B), each cylindrical cell extending between opposed first and second ends in a direction perpendicular to a plane of the array;
a plurality of flexible printed circuit boards, PCBs (35), each flexible PCB provided between two adjacent rows of the plurality of rows of cells, the plurality of flexible PCBs including a first flexible PCB provided between the adjacent first and second rows (A, B) and a second flexible PCB provided between the adjacent second and third rows (B, C);
a plurality of sensor carriers (38) separate to the flexible PCBs, each sensor carrier comprising an aperture for receiving a temperature sensor (36) in the direction perpendicular to the plane of the array, each sensor carrier being located in a gap formed between cells of two adjacent rows; and
a plurality of temperature sensors (36), each temperature sensor received within the aperture of one of the sensor carriers, each temperature sensor electrically connected to one of the plurality of flexible PCB, each respective temperature sensor being operable to sense a temperature of one or more cells of the respective two adjacent rows.

2. The battery assembly (30) of claim 1, wherein the sensor carriers (38) are shaped to cooperate with shapes of the cells (34) surrounding a gap (37) formed between cells (34) of the two adjacent rows (A, B; B, C).

3. The battery assembly (30) of claim 2, wherein the sensor carriers (38) comprise arcuate extensions for cooperating with the shape of cells of circular cross-section.

4. The battery assembly (30) of any one of the preceding claims, wherein the cells (34) of adjacent rows (A, B; B, C) of the array (31) are offset with respect to each other, and wherein each temperature sensor (36) is provided in a gap (37) formed between a group of three cells (34i, 34ii, 34iii), the three cells consisting of first and second cells (34i, 34ii) belonging to one of the two rows (A) and a third cell (34iii) belonging to the other of the two rows (B) and adjacent to the first and second cells.

5. The battery assembly (30) of any one of the preceding claims, wherein each flexible PCB (35) is attached to side walls (341) of the cells (34) of one or both of the two adjacent rows (A, B; B, C).

6. The battery assembly of claim 5, wherein each flexible PCB (35) is adhesively attached to side walls (341) of the cells (34) of one or both of the two adjacent rows (A, B; B, C).

7. The battery assembly (30) of any one of the preceding claims, further comprising an additional flexible PCB (39) affixed to an outer facing surface of the cells (34) of an outermost row (A, E) of the array, wherein the additional flexible PCB is electrically coupled to at least one additional temperature sensor (36), each of the said additional temperature sensors operable to sense a temperature of one or more cells (34) of the outermost row.

8. The battery assembly (30) of any one of the preceding claims, wherein each cell (34) has a side wall (341) extending generally perpendicular to a plane of the array (31), and wherein each temperature sensor (36) is positioned at the same distance (D) along the side wall.

9. The battery assembly (30) of any one of the preceding claims, wherein the cells of each respective row of cells (A, B, C, D, E) are electrically connected together in parallel.

10. An aircraft propulsion system (10, 200, 300) comprising a battery assembly (30) as claimed in any one of claims 1 to 9.

11. An aircraft comprising a battery assembly (30) as claimed in any one of claims 1 to 9 or comprising the aircraft propulsion system (200, 300) of claim 10

## Patentansprüche

1. Batteriebaugruppe (30), umfassend:
eine Anordnung (31) aus zylindrischen Batteriezellen (34), wobei die Anordnung mehrere Reihen (A-E) umfasst, wobei jede Reihe mehrere zylindrische Zellen umfasst, wobei die mehreren Reihen zumindest eine erste Reihe (A), eine zweite Reihe (B) benachbart zu der ersten Reihe und eine dritte Reihe (C) benachbart zu der zweiten Reihe (B) beinhalten, wobei sich jede zylindrische Zelle zwischen gegenüberliegenden ersten und zweiten Enden in einer Richtung senkrecht zu einer Ebene der Anordnung erstreckt,
eine Vielzahl von flexiblen Leiterplatten, PCBs (35), wobei jede flexible PCB zwischen zwei benachbarten Reihen aus der Vielzahl von Reihen von Zellen bereitgestellt ist, wobei die Vielzahl von flexiblen PCBs eine erste flexible PCB, bereitgestellt zwischen der benachbarten ersten und zweiten Reihe (A, B), und eine zweite flexible PCB, bereitgestellt zwischen der benachbarten zweiten und dritten Reihe (B, C), beinhaltet;
eine Vielzahl von Sensorträgern (38) separat zu den flexiblen PCBs, wobei jeder Sensorträger eine Öffnung zum Aufnehmen eines Temperatursensors (36) in der Richtung senkrecht zu der Ebene der Anordnung umfasst, wobei sich jeder Sensorträger in einem Spalt befindet, der zwischen Zellen von zwei benachbarten Reihen gebildet ist, und
eine Vielzahl von Temperatursensoren (36), wobei jeder Temperatursensor innerhalb der Öffnung von einem der Sensorträger aufgenommen ist, wobei jeder Temperatursensor elektrisch mit einer aus der Vielzahl von flexiblen PCB verbunden ist, wobei jeder jeweilige Temperatursensor bedienbar ist, um eine Temperatur von einer oder mehreren Zellen der jeweiligen zwei benachbarten Reihen zu erfassen.

2. Batteriebaugruppe (30) nach Anspruch 1, wobei die Sensorträger (38) geformt sind, um mit Formen der Zellen (34) zusammenwirken, die einen Spalt (37) umgeben, der zwischen Zellen (34) der zwei benachbarten Reihen (A, B; B, C) gebildet ist.

3. Batteriebaugruppe (30) nach Anspruch 2, wobei die Sensorträger (38) bogenförmige Verlängerungen zum Zusammenwirken mit der Form von Zellen mit kreisförmigem Querschnitt umfassen.

4. Batteriebaugruppe (30) nach einem der vorhergehenden Ansprüche, wobei die Zellen (34) von benachbarten Reihen (A, B; B, C) der Anordnung (31) in Bezug zueinander versetzt sind, und wobei jeder Temperatursensor (36) in einem Spalt (37) bereitgestellt ist, der zwischen einer Gruppe von drei Zellen (34i, 34ii, 34iii) gebildet ist, wobei die drei Zellen aus ersten und zweiten Zellen (34i, 34ii), die zu einer der zwei Reihen (A) gehören, und einer dritten Zelle (34iii), die zu der anderen von den zwei Reihen (B) gehört und benachbart zu der ersten und der zweiten Zelle ist, bestehen.

5. Batteriebaugruppe (30) nach einem der vorhergehenden Ansprüche, wobei jede flexible PCB (35) an Seitenwänden (341) der Zellen (34) von einer oder beiden der zwei benachbarten Reihen (A, B; B, C) angebracht ist.

6. Batteriebaugruppe nach Anspruch 5, wobei jede flexible PCB (35) haftend an Seitenwänden (341) der Zellen (34) von einer oder beiden der zwei benachbarten Reihen (A, B; B, C) angebracht ist.

7. Batteriebaugruppe (30) nach einem der vorhergehenden Ansprüche, ferner umfassend eine zusätzliche flexible PCB (39), die an einer nach außen gerichteten Oberfläche der Zellen (34) einer äußersten Reihe (A, E) der Anordnung befestigt ist, wobei die zusätzliche flexible PCB elektrisch an zumindest einen zusätzlichen Temperatursensor (36) gekoppelt ist, wobei jeder der zusätzlichen Temperatursensoren bedienbar ist, um eine Temperatur von einer oder mehreren Zellen (34) der äußersten Reihe zu erfassen.

8. Batteriebaugruppe (30) nach einem der vorhergehenden Ansprüche, wobei jede Zelle (34) eine Seitenwand (341) aufweist, die sich im Allgemeinen senkrecht zu einer Ebene der Anordnung (31) erstreckt, und wobei jeder Temperatursensor (36) in dem gleichen Abstand (D) entlang der Seitenwand positioniert ist.

9. Batteriebaugruppe (30) nach einem der vorhergehenden Ansprüche, wobei die Zellen von jeder jeweiligen Reihe von Zellen (A, B, C, D, E) elektrisch parallel miteinander verbunden sind.

10. Luftfahrzeugantriebssystem (10, 200, 300), das eine Batteriebaugruppe (30) nach einem der Ansprüche 1 bis 9 umfasst.

11. Luftfahrzeug, das eine Batteriebaugruppe (30) nach einem der Ansprüche 1 bis 9 umfasst oder das Luftfahrzeugantriebssystem (200, 300) nach Anspruch 10 umfasst.

## Revendications

1. Ensemble batterie (30) comprenant :
un réseau (31) de cellules de batterie cylindriques (34), le réseau comprenant plusieurs rangées (A-E), chaque rangée comprenant plusieurs cellules cylindriques, les plusieurs rangées comprenant au moins une première rangée (A), une deuxième rangée (B) adjacente à la première rangée, et une troisième rangée (C) adjacente à la deuxième rangée (B), chaque cellule cylindrique s'étendant entre des première et deuxième extrémités opposées dans une direction perpendiculaire à un plan du réseau ;
une pluralité de cartes de circuits imprimés souples, PCB (35), chaque PCB souple étant prévu entre deux rangées adjacentes de la pluralité de rangées de cellules, la pluralité de PCB souples comprenant une première PCB souple prévue entre les première et deuxième rangées adjacentes (A, B) et une seconde PCB souple prévue entre les deuxième et troisième rangées adjacentes (B, C) ;
une pluralité de supports de capteur (38) séparés des PCB souples, chaque support de capteur comprenant une ouverture pour recevoir un capteur de température (36) dans la direction perpendiculaire au plan du réseau, chaque support de capteur étant situé dans un espace formé entre des cellules de deux rangées adjacentes ; et
une pluralité de capteurs de température (36), chaque capteur de température étant reçu dans l'ouverture de l'un des supports de capteurs, chaque capteur de température étant électriquement connecté à l'une de la pluralité de PCB souples, chaque capteur de température respectif servant à détecter une température d'une ou plusieurs cellules des deux rangées adjacentes respectives.

2. Ensemble batterie (30) de la revendication 1, lesdits supports de capteur (38) étant façonnés pour coopérer avec des formes des cellules (34) entourant un espace (37) formé entre des cellules (34) des deux rangées adjacentes (A, B ; B, C).

3. Ensemble batterie (30) de la revendication 2, lesdits supports de capteur (38) comprenant des extensions arquées pour coopérer avec la forme des cellules de section transversale circulaire.

4. Ensemble batterie (30) de l'une quelconque des revendications précédentes, lesdites cellules (34) des rangées adjacentes (A, B ; B, C) du réseau (31) étant décalées les unes par rapport aux autres, et chaque capteur de température (36) étant prévu dans un espace (37) formé entre un groupe de trois cellules (34i, 34ii, 34iii), les trois cellules étant constituées de première et deuxième cellules (34i, 34ii) appartenant à l'une des deux rangées (A) et une troisième cellule (34iii) appartenant à l'autre des deux rangées (B) et adjacentes aux première et deuxième cellules.

5. Ensemble batterie (30) de l'une quelconque des revendications précédentes, chaque PCB souple (35) étant fixé aux parois latérales (341) des cellules (34) de l'une ou les deux des deux rangées adjacentes (A, B ; B, C).

6. Ensemble batterie de la revendications 5, chaque PCB souple (35) étant attaché par adhésif aux parois latérales (341) des cellules (34) de l'une ou des deux des deux rangées adjacentes (A, B ; B, C).

7. Ensemble batterie (30) de l'une quelconque des revendications précédentes, comprenant en outre une PCB souple supplémentaire (39) fixée à une surface orientée vers l'extérieur des cellules (34) d'une rangée la plus externe (A, E) du réseau, ladite PCB souple supplémentaire étant électriquement couplée à au moins un capteur de température supplémentaire (36), chacun desdits capteurs de température supplémentaires servant à détecter une température d'une ou plusieurs cellules (34) de la rangée la plus externe.

8. Ensemble batterie (30) de l'une quelconque des revendications précédentes, chaque cellule (34) comportant une paroi latérale (341) s'étendant globalement perpendiculaire à un plan du réseau (31), et chaque capteur de température (36) étant positionné à la même distance (D) le long de la paroi latérale.

9. Ensemble batterie (30) de l'une quelconque des revendications précédentes, lesdites cellules de chaque rangée respective de cellules (A, B, C, D, E) étant électriquement connectées ensemble en parallèle.

10. Système de propulsion d'aéronef (10, 200, 300) comprenant un ensemble batterie (30) de l'une quelconque des revendications 1 à 9.

11. Aéronef comprenant un ensemble batterie (30) de l'une quelconque des revendications 1 à 9 ou comprenant le système de propulsion d'aéronef (200, 300) de la revendication 10.
